# EUROPEAN PATENT SPECIFICATION

(11) **EP 4 346 045 B1**
(45) Date of publication and mention of the grant of the patent: **27.05.2026**
(21) Application number: 23199027.6
(22) Date of filing: 22.09.2023
(51) Int. Cl.: B60L 53/22, H05K 7/20

(54) **CHARGING MODULE AND CHARGING PILE**
LADEMODUL UND LADESÄULE
MODULE DE CHARGE ET PILE DE CHARGE

(30) Priority: 29.09.2022 CN 202222591158 U
(43) Date of publication of application: 03.04.2024
(73) Proprietor: Huawei Digital Power Technologies Co., Ltd., Shenzhen, Guangdong 518043 (CN)
(72) Inventor: LIU, Lin, Shenzhen, 518043 (CN); XU, Qinxun, Shenzhen, 518043 (CN); XIE, Wangkun, Shenzhen, 518043 (CN); YAN, Chengzhang, Shenzhen, 518043 (CN)
(74) Representative: Gill Jennings & Every LLP

(56) References cited:
- CN-A- 110 936 841
- CN-A- 112 096 660
- US-A1- 2016 165 716
- US-A1- 2018 191 183
- US-A1- 2022 123 580

## Description

### TECHNICAL FIELD

This application relates to the technical field of electric vehicle charging piles, and in particular, to a charging module and a charging pile.

### BACKGROUND

With development of the electric vehicle charging industry, users impose a higher requirement on charging time of vehicles. To improve user experience and meet a requirement of fast charging, power of a charging pile is set to be increasingly large. Therefore, costs and power density of a charging module also continuously increase. As the power density continuously increases, noise generated when the charging module works is also expected to be reduced. This imposes a higher requirement on a layout design of the charging module.

Generally, a power switching transistor and a capacitor on a rectification side are placed separately. A power switching transistor and a magnetic device on a conversion side of a direct current-direct current converter (DC-to-DC converter, DCDC) are arranged in series in a straight line in an air duct. A distance between the power switching transistor and the capacitor on a rectifying plate is long. The capacitor has a poor absorption effect on voltage and current spikes generated when the power switching transistor works, and consequently a current or voltage spike of a power conversion circuit is high. A large current change rate (di/dt) and a large voltage change rate (dv/dt) further exist in a working process of the power switching transistor. These foregoing factors all cause problems such as electromagnetic interference (Electromagnetic Interference, EMI for short), and consequently electromagnetic compatibility (Electromagnetic Compatibility, EMC) is poor, and reliability of a device also decreases. A heat sink of the power switching transistor and the magnetic device of a DCDC plate are connected in series in a straight line in the air duct. This further causes an increase in air resistance and directly affects an actual heat dissipation effect of the heat sink of the power switching transistor. The device is in a high-temperature working state for a long time, and consequently the device is easily damaged, thereby increasing costs.

CN 110 936 841 A discloses a cooling component having a heat sink with one or more grooves and heat dissipation fins to form one or more heat dissipation channels. High-heating components are placed within these channels and are isolated from low-heating components by partition plates.

US 2016/165716 A1 discloses a power conversion apparatus comprising a cooling body that utilizes liquid cooling to cool both an AC/DC converter and a DC/DC converter. US 2018/191183 A1 discloses a battery-charging module that defines a straight, forced-air cooling flow path from one side of the module's housing to the other.

### SUMMARY

Embodiments of this application provide a charging module and a charging pile. In a charging process, current and voltage spikes are small, and electromagnetic interference is small. In addition, air resistance of an air duct in the module is small, a heat dissipation effect is good, noise is low, and reliability is high, so that costs can be reduced.

According to a first aspect, a charging module is provided and includes: a housing, including an upper housing and a lower housing that are fitted to each other, where an air inlet and an air outlet are respectively disposed on two opposite sides of the housing; a rectifying plate, fixedly disposed on the upper housing, where a first power conversion circuit including a plurality of first power switching transistors is disposed on the rectifying plate, the rectifying plate includes a first end portion and a second end portion, and the plurality of first power switching transistors are disposed at the first end portion; and a direct current conversion plate, fixedly disposed on the lower housing, where a second power conversion circuit including a plurality of second power switching transistors is disposed on the direct current conversion plate, and the plurality of second power switching transistors are all disposed at one end portion of the direct current conversion plate and are close to the first power switching transistors. An air duct is disposed between the rectifying plate and the direct current conversion plate. The air duct is parallel to the rectifying plate and the direct current conversion plate. Two ends of the air duct are respectively connected to the air inlet and the air outlet. A flow path of an airflow in the air duct is in a straight line.

In this implementation of this application, power switching transistors with a large amount of generated heat are disposed at an end portion of the rectifying plate or the direct current conversion plate, which helps air-cooled heat dissipation. In addition, there is a gap between devices located in the air duct, which also helps flowing of air. No device that generates large air resistance is disposed in the air duct. The air duct is relatively independent. There are no devices that are coupled in series in the air duct, so that air flows smoothly, and a heat dissipation effect is good.

In a possible implementation, the first end portion is disposed at the air inlet, and the second end portion is disposed at the air outlet.

In this implementation of this application, the first end portion at which the plurality of power switching transistors are disposed is disposed at the air inlet. The second end portion is disposed at the air outlet. Because the air inlet is opposite to the air outlet, and a direct ventilation air duct is formed, the airflow flows from the first end portion to the second end portion. Direct ventilation helps rapidly discharge hot air from the housing, so that the heat dissipation effect is improved.

The first power conversion circuit further includes a plurality of first capacitors and a plurality of first electromagnetic devices. The plurality of first capacitors are disposed between adjacent first power switching transistors. There is a gap between each first capacitor and the first power switching transistor. The plurality of first electromagnetic devices are located between the first end portion and the second end portion. There is a gap between the plurality of first electromagnetic devices.

The plurality of capacitors are disposed near the power switching transistors, which helps absorb current and voltage spikes generated when the power switching transistors work, so that an electromagnetic interference problem is not easily caused, and stability of the power conversion circuit is improved. There is a gap between a plurality of electromagnetic devices with the large amount of generated heat, which helps the flowing of air and improves heat dissipation efficiency.

In a possible implementation, the second power conversion circuit further includes a plurality of second capacitors and a plurality of second electromagnetic devices. The plurality of second capacitors are disposed between adjacent second power switching transistors. There is a gap between each second capacitor and the second power switching transistor. The plurality of second electromagnetic devices are located on two sides of the air duct. There is a gap between the plurality of second electromagnetic devices.

The plurality of capacitors are disposed near the power switching transistors, which helps absorb current and voltage spikes generated when the power switching transistors work, so that an electromagnetic interference problem is not easily caused, and stability of the power conversion circuit is improved. There is a gap between the plurality of electromagnetic devices with the large amount of generated heat, which helps the flowing of air and improves the heat dissipation efficiency.

In a possible implementation, in the housing, there is a gap between devices on the rectifying plate and the devices on the direct current conversion plate.

The rectifying plate is fastened on the upper housing. The direct current conversion plate is fastened on the lower housing. After the upper housing and the lower housing are fitted, the devices on the rectifying plate and the devices on the direct current conversion plate are in an opposite state. In this state, there is a gap between the devices on the rectifying plate and the devices on the direct current conversion plate, which helps reduce the air resistance of the air duct. In addition, the devices on the rectifying plate are not in contact with the devices on the direct current conversion plate, so that an electromagnetic interference phenomenon is not easily caused. That the devices are not in contact with each other also reduces damage caused by mutual collision between the devices, so that costs are saved.

The charging module further includes: a plurality of first heat sinks, fixedly attached to the first power switching transistors. Each first heat sink corresponds to at least one first power switching transistor. Any one of the plurality of first heat sinks includes a plurality of heat dissipation fins that are disposed in parallel. All the heat dissipation fins are disposed in a direction from the air inlet to the air outlet.

The plurality of heat sinks are used for heat dissipation. Fins of the heat sinks are disposed in the air duct. The fins of the heat sinks are disposed in a same direction as an airflow direction. A gap between the fins of the heat sinks may be used as a part of the air duct. Because the fins of the heat sinks are disposed in the same direction as the airflow direction, when air flows through the gap between the fins of the heat sinks, the air resistance is smaller, and the heat dissipation effect is better.

In a possible implementation, the charging module further includes: a plurality of second heat sinks, fixedly attached to the second power switching transistors. Each second heat sink corresponds to at least one second power switching transistor. Any one of the plurality of second heat sinks includes a plurality of heat dissipation fins that are disposed in parallel. All the heat dissipation fins are disposed in the direction from the air inlet to the air outlet.

The plurality of heat sinks are used for heat dissipation. Fins of the heat sinks are disposed in the air duct. The fins of the heat sinks are disposed in a same direction as the airflow direction. A gap between the fins of the heat sinks may be used as a part of the air duct. Because the fins of the heat sinks are disposed in the same direction as the airflow direction, when air flows through the gap between the fins of the heat sinks, the air resistance is smaller, and the heat dissipation effect is better.

In a possible implementation, shapes of the plurality of heat sinks are rectangular.

The rectifying plate is further provided with: a shielding cover, fastened at the second end portion of the rectifying plate. An electromagnetic compatibility circuit including a plurality of first magnetic devices is disposed in the shielding cover.

The shielding cover is used to shield electromagnetic interference that may be generated by the electromagnetic compatibility circuit, which helps improve the stability of the power conversion circuit.

In a possible implementation, a plurality of air vents are disposed on the shielding cover.

The shielding cover is located at one end of the air duct and is close to the air outlet. The plurality of air vents are disposed on the shielding cover to reduce the air resistance at the air outlet. The airflow easily flows out rapidly from the air outlet, so that an air cooling effect is improved.

Mounting heights of the plurality of first heat sinks, the plurality of first electromagnetic devices, and the shielding cover are consistent.

That the heights of devices, such as the heat sinks and the electromagnetic devices, on the rectifying plate are set to be consistent helps a space layout in the housing, and can implement arrangement of the power conversion circuit in small space, so that occupied space is small. In addition, the devices of the consistent heights on the rectifying plate can reduce the air resistance and noise when the airflow passes through.

In a possible implementation, mounting heights of the plurality of second heat sinks and the plurality of second electromagnetic devices are consistent.

That the heights of devices, such as the heat sinks and the electromagnetic devices, on the direct current conversion plate are set to be consistent helps the space layout in the housing, and can implement arrangement of the power conversion circuit in small space, so that the occupied space is small. In addition, the devices of the consistent heights on the direct current conversion plate can reduce the air resistance and noise when the airflow passes through.

In a possible implementation, the housing further includes: a panel, located at the air inlet and fixedly connected to the upper housing and the lower housing, where a plurality of air vents are disposed on the panel; and at least one fan, disposed at the panel, mounted in the housing, and configured to introduce air into the housing.

The plurality of air vents are disposed on the panel for air intake. External air may be introduced into the housing by using the fan disposed at the panel, and then flow out from the other end of the housing through the air duct. The air resistance of the air duct disposed in a straight line is small, and the heat dissipation efficiency is high.

In another aspect, a charging pile is provided, is configured to charge a power battery of a vehicle, and includes at least one the foregoing charging module. Rectification and direct current conversion are performed on an alternating current power supply by using the charging module.

In this implementation of this application, rectification and direct current conversion are performed on an external alternating current by using the foregoing charging module, to convert the external alternating current to a direct current that meets a charging requirement of the power battery of the vehicle, so as to charge the power battery of the vehicle. In a charging process, current and voltage spikes are small, electromagnetic interference is small, air resistance of an air duct is small, a heat dissipation effect in the module is good, noise is low, and reliability is high. In addition, a volume of the charging module is small, so that a volume of the charging pile can be correspondingly reduced, and manufacturing costs can be reduced.

According to still another aspect, a charging pile is provided, is configured to charge a power battery of a vehicle, and includes a charging pile housing, a main control board, and at least one charging module. The main control board and the charging module are disposed in the charging pile housing. The main control board is connected to the charging module and is configured to control running of the charging module. The charging module includes a rectifying plate and a direct current conversion plate. The rectifying plate and the direct current conversion plate are disposed in a fitted manner. The rectifying plate and the direct current conversion plate share a same air duct for heat dissipation. An air inlet and an air outlet of the air duct are respectively disposed at two ends of the rectifying plate and the direct current conversion plate.

The charging module with direct ventilation heat dissipation is used to charge the power battery of the vehicle. In a charging process, current and voltage spikes are small, electromagnetic interference is small, air resistance of the air duct is small, a heat dissipation effect in the module is good, noise is low, and reliability is high.

In a possible implementation, the charging module further includes a housing. The housing includes an upper housing and a lower housing. The rectifying plate is fixedly disposed on the upper housing. A first power conversion circuit including a plurality of first power switching transistors is disposed on the rectifying plate, and is configured to convert an externally input alternating current to a direct current. The direct current conversion plate is fixedly disposed on the lower housing. A second power conversion circuit including a plurality of second power switching transistors is disposed on the direct current conversion plate, and is configured to convert a voltage of the direct current.

The first power conversion circuit includes the plurality of first power switching transistors, a plurality of first capacitors, a plurality of first electromagnetic devices, and a plurality of first heat sinks. The plurality of first capacitors are disposed between adjacent first power switching transistors. There is a gap between each first capacitor and the first power switching transistor. The plurality of first electromagnetic devices are located at the middle of the rectifying plate. There is a gap between the plurality of first electromagnetic devices. The plurality of first heat sinks are fixedly attached to the first power switching transistors. Each first heat sink corresponds to at least one first power switching transistor. Any one of the plurality of first heat sinks includes a plurality of heat dissipation fins that are disposed in parallel. All the heat dissipation fins are disposed in a direction from the air inlet to the air outlet.

In a possible implementation, the second power conversion circuit includes the plurality of second power switching transistors, a plurality of second capacitors, a plurality of second electromagnetic devices, and a plurality of second heat sinks. The plurality of second capacitors are disposed between adjacent second power switching transistors. There is a gap between each second capacitor and the second power switching transistor. The plurality of second electromagnetic devices are located on two sides of the air duct. There is a gap between the plurality of second electromagnetic devices. The plurality of second heat sinks are fixedly attached to the second power switching transistors. Each second heat sink corresponds to at least one second power switching transistor. Any one of the plurality of second heat sinks includes a plurality of heat dissipation fins that are disposed in parallel. All the heat dissipation fins are disposed in the direction from the air inlet to the air outlet.

In a possible implementation, the charging module further includes at least one fan, disposed at the air inlet and configured to introduce air into the housing.

### BRIEF DESCRIPTION OF DRAWINGS

FIG. 1 is a schematic diagram of a structure of a system of a charging pile;
FIG. 2 is an exploded diagram of a structure of a charging module;
FIG. 3 is a schematic diagram of a structure of a module layout of a rectifying plate; and
FIG. 4 is a schematic diagram of a structure of a module layout of a direct current conversion plate.

### DESCRIPTION OF EMBODIMENTS

Charging piles of new energy vehicles usually convert an alternating current to a direct current that meets a requirement in manners of rectification and direct current conversion, and then charge power batteries of the vehicles. This conversion process is generally implemented by using a charging module. When the charging module works, there is a requirement for heat dissipation. Air-cooled heat dissipation is a commonly used technical means at present. With development of fast charging technologies, output power of the charging piles is increasingly large. A current and a voltage of a power circuit greatly fluctuate. A current spike and a voltage spike are frequently generated. An electromagnetic interference phenomenon is frequently generated. This causes an unstable power conversion circuit. In addition, an amount of generated heat of a power conversion module is increasingly high. A conventional layout solution of the charging module cannot meet requirements for stable running and heat dissipation of a high-power module. A technical bottleneck is generated.

Functions of the charging piles are similar to those of fuel nozzles at gas stations. The charging piles may be fixed on the ground or walls, may be mounted in commercial buildings (for example, commercial buildings, large shopping malls, and public parking lots) and underground parking lots in communities, and may charge batteries of various types of electric vehicles based on different rated voltages. Import ends of the charging piles are immediately connected to an alternating current power grid, and most output ends are equipped with a charger plug to charge the batteries of the electric vehicles. Most charging piles have basic battery charging and fast charging for users to choose. The charging piles are provided with a display, and the display may display related information such as a charging amount, costs, and battery charging time.

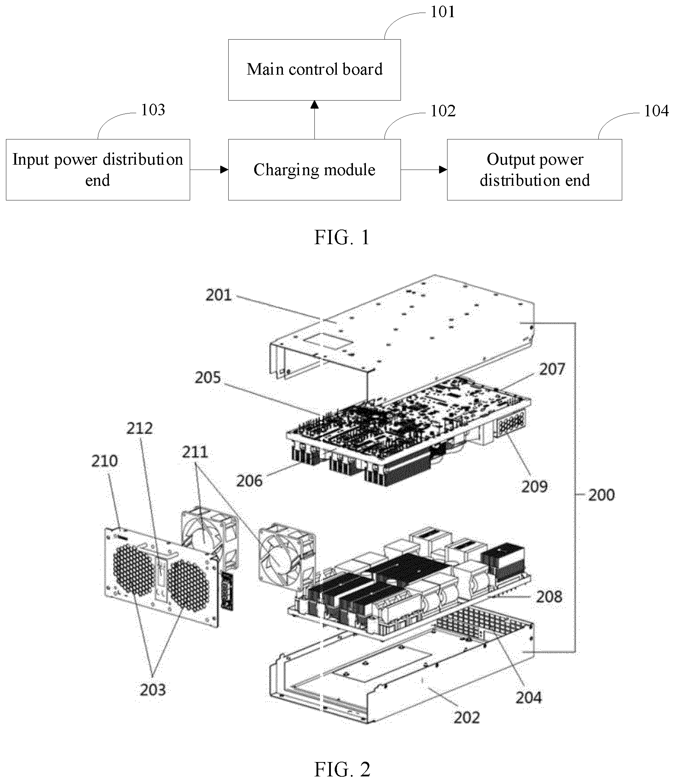

FIG. 1 is a schematic diagram of a structure of a system of a charging pile. As shown in FIG. 1, this application provides a charging pile. The charging pile is configured to charge a power battery of a vehicle and includes a charging pile housing, a main control board 101, and a charging module 102. The main control board 101 and the charging module 102 are disposed in the charging pile housing. The main control board 101 is connected to the charging module 102 and is configured to control running of the charging module 102. The charging module 102 includes a rectifier and a direct current converter. The rectifier and the direct current converter are disposed in a fitted manner. The rectifier and the direct current converter share a same air duct for heat dissipation. An air inlet and an air outlet of the air duct are respectively disposed at two ends of the rectifier and the direct current converter. In addition, the charging pile further includes an input power distribution end 103 and an output power distribution end 104. The input power distribution end 103 and the output power distribution end 104 both include switches such as a contactor and a circuit breaker, and are input and output ports of the charging pile. The main control board 101 and the charging module 102 are disposed between the input power distribution end 103 and the output power distribution end 104. The main control board 101 controls an alternating current of the input power distribution end 103 to be converted by the charging module 102 and finally output from the output power distribution end 104, to charge a battery of an electric vehicle. It may be understood that the input power distribution end 103 is connected to an external alternating current power supply.

A housing of the charging module 102 includes an upper housing and a lower housing. A rectifier is fixedly disposed on the upper housing. A first power conversion circuit including a plurality of first power switching transistors is disposed on the rectifier, and is configured to convert an externally input alternating current to a direct current. The direct current converter is fixedly disposed on the lower housing. A second power conversion circuit including a plurality of second power switching transistors is disposed on a direct current conversion plate, and is configured to convert a voltage of the direct current.

The first power conversion circuit includes the plurality of first power switching transistors, a plurality of first capacitors, a plurality of first electromagnetic devices, and a plurality of first heat sinks. The plurality of first capacitors are disposed between adjacent first power switching transistors. There is a gap between each first capacitor and the first power switching transistor. The plurality of first electromagnetic devices are located at the middle of the rectifier. There is a gap between the plurality of first electromagnetic devices. The plurality of first heat sinks are fixedly attached to the first power switching transistors. Each first heat sink corresponds to at least one first power switching transistor. Any one of the plurality of first heat sinks includes a plurality of heat dissipation fins that are disposed in parallel. All the heat dissipation fins are disposed in a direction from the air inlet to the air outlet.

The second power conversion circuit also includes the plurality of second power switching transistors, a plurality of second capacitors, a plurality of second electromagnetic devices, and a plurality of second heat sinks. The plurality of second capacitors are disposed between adjacent second power switching transistors. There is a gap between each second capacitor and the second power switching transistor. The plurality of second electromagnetic devices are located on two sides of the air duct. There is a gap between the plurality of second electromagnetic devices. The plurality of second heat sinks are fixedly attached to the second power switching transistors. Each second heat sink corresponds to at least one second power switching transistor. Any one of the plurality of second heat sinks includes a plurality of heat dissipation fins that are disposed in parallel. All the heat dissipation fins are disposed in the direction from the air inlet to the air outlet.

In a possible implementation, the charging module 102 further includes at least one fan, disposed at the air inlet and configured to introduce air into the housing.

In the charging module used in this embodiment of this application, the rectifier and the direct current converter are disposed in a fitted manner. The rectifier and the direct current converter share one air duct for heat dissipation. The fan is disposed at the air inlet of the air duct, to control an airflow to flow from the air inlet to the air outlet and flow out from the air outlet. A specific gap is set between the devices on the rectifier and on the direct current converter to ensure flowing of the airflow. There is a specific distance between the rectifier and the direct current converter. In addition, no device that causes excessively high air resistance is disposed in the air duct, so that the air resistance in a direct ventilation air duct is as small as possible. This helps heat dissipation. When the airflow flows through the air duct, no large noise is generated due to the small air resistance.

This application further provides a layout solution of a charging module. FIG. 2 is an exploded diagram of a structure of a charging module. As shown in FIG. 2. the charging module includes a housing 200, a panel 210, a fan 211, a rectifier, and a direct current converter. The housing 200 includes an upper housing 201 and a lower housing 202 that are fitted to each other. An air inlet 203 and an air outlet 204 may further be disposed on two sides of the housing for ventilation, to implement air-cooled heat dissipation.

The housing 200 may further include: a panel 210, where the panel 210 is located at the air inlet 203 and fixedly connected to the upper housing 201 and the lower housing 202, and a plurality of air vents are disposed on the panel 210; and at least one fan 211, disposed at the panel 210, mounted in the housing 200, and configured to introduce air into the housing 200. The plurality of air vents are disposed on the panel 210 for air intake. External air may be introduced into the housing 200 by using the fan 211 disposed at the panel 210, and then flow out from the other end of the housing 200 through an air duct. Air resistance of an air duct disposed in a straight line is small, and heat dissipation efficiency is high.

A rectifying plate 205 and a direct current conversion plate 208 are disposed in the housing 200 for alternating current-direct current conversion and direct current-direct current conversion. The rectifying plate 205 and the direct current conversion plate 208 are each provided with a power conversion circuit, and integrate a plurality of power switching transistors 13, capacitors, and a plurality of magnetic members (such as a transformer and an inductor). The capacitors are configured to filter a current or voltage spike generated when the power conversion circuit works, thereby reducing electromagnetic interference in the circuit. The power conversion circuit of the rectifying plate 205 is configured to convert an alternating current to a direct current. The power conversion circuit of the direct current conversion plate 208 is configured to change a voltage of the direct current to meet a voltage output requirement. It may be understood that the charging module first converts an input alternating current into a direct current by using the rectifying plate 205, and then converts the voltage of the direct current by using the direct current conversion plate 208.

The air duct is disposed between the rectifying plate 205 and the direct current conversion plate 208, and is used as a channel for air-cooled heat dissipation. The air duct is located on a same straight line with the air inlet 203 and the air outlet 204, so that direct ventilation-type heat dissipation can be implemented, and a heat dissipation effect is good.

An LED display screen 212 or a control button may further be disposed on the housing for displaying information such as a temperature, a current, and a voltage. The control button may control turning on and turning off of the fan 211, input user instructions, and the like.

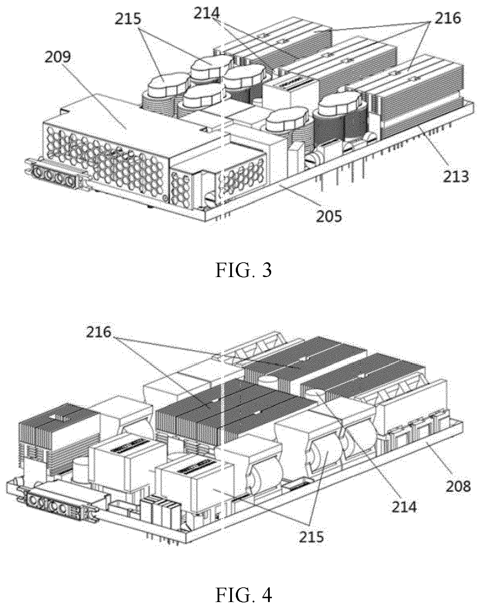

FIG. 3 is a schematic diagram of a structure of a module layout of a rectifying plate. With reference to FIG. 2 and FIG. 3, a rectifier includes a rectifying plate 205, a plurality of power switching transistors 213, a plurality of capacitors 214, and magnetic devices. The power conversion circuit including the plurality of power switching transistors 213, the plurality of capacitors 214, and a plurality of electromagnetic devices 215 is configured to convert an external alternating current to a direct current. The rectifying plate 205 is fixedly disposed on the upper housing 201 and includes a first end portion 206 and a second end portion 207. The first end portion 206 is located at an air inlet 203. The second end portion 207 is located at an air outlet 204. The plurality of power switching transistors 213 and the plurality of capacitors 214 are disposed at the first end portion 206 of the rectifying plate 205 and are close to the air inlet 203. The plurality of capacitors 214 are disposed between adjacent power switching transistors 213. There is a gap between the plurality of capacitors 214 and the power switching transistors 213, so that air resistance can be reduced, air flow is facilitated, and heat dissipation efficiency is improved. The plurality of electromagnetic devices 215 are disposed at the middle of the rectifying plate 205, and may be disposed between the first end portion 206 and the second end portion 207. In addition, there is a gap between the plurality of electromagnetic devices 215, so as to reduce the air resistance and improve the heat dissipation efficiency. The magnetic devices include but are not limited to an inductor, a transformer, and the like.

FIG. 4 is a schematic diagram of a structure of a module layout of a direct current conversion plate. With reference to FIG. 2 and FIG. 4, the direct current conversion plate 208 is fixedly disposed on a lower housing 202. A power conversion circuit including a plurality of power switching transistors 213, a plurality of capacitors 214, and a plurality of magnetic devices is included in the direct current conversion plate 208 and is configured to convert a voltage of a rectified direct current, so that an output charging voltage meets a charging voltage of a power battery of a vehicle. The plurality of power switching transistors 213 are disposed at one end of the direct current conversion plate 208 in a centralized manner and are located at an air inlet 203. The plurality of capacitors 214 are also disposed near the power switching transistors 213 and are configured to absorb current and voltage spikes generated by a power conversion circuit, thereby reducing voltage fluctuation, and enhancing stability of the power conversion circuit. In addition, the plurality of magnetic devices may be disposed at edges of two sides of an air duct. There is a gap between a plurality of electromagnetic devices 215. Air may flow in the gap, so as to reduce air resistance and improve heat dissipation efficiency.

In some embodiments, in the air duct, in particular, a path from the air inlet 203 to an air outlet 204 is a path through which an airflow mainly passes. No device with large air resistance is disposed on the path, and no device, such as a horizontal plate, that hinders a flow direction of the airflow is disposed on the path. This can significantly reduce the air resistance of the airflow in the air duct, so that the airflow after heat exchange may rapidly flow out from the air outlet 204 through the air duct, and heat is rapidly discharged from the housing 202, thereby significantly improving the heat dissipation efficiency.

In this embodiment of this application, the plurality of capacitors 214 are disposed near the power switching transistors 213, which helps absorb current and voltage spikes generated when the power switching transistors 213 work and can reduce voltage fluctuation, so that an electromagnetic interference problem is not easily caused, and stability of the power conversion circuit is improved. In addition, the power switching transistors 213 with a large amount of generated heat are disposed at the air inlet 203. There is a gap between devices located in the air duct, which helps flowing of air. No device that generates large air resistance is disposed in the air duct. The air duct is relatively independent. There are no devices that are coupled in series in the air duct, so that the air resistance is small, and a heat dissipation effect is good.

In another possible embodiment, the plurality of power switching transistors 213 and the plurality of capacitors 214 disposed on the rectifying plate 205 in the previous embodiment may further be disposed at a second end portion 207, that is, a place close to the air outlet. The plurality of power switching transistors 213 and the plurality of magnetic devices disposed on the direct current conversion plate 208 in the previous embodiment are disposed at the other end of the direct current conversion plate, that is, a place close to the air outlet. A gap is provided between other devices. The devices are arranged in order in the air duct. No device that generates large air resistance is disposed. The air duct is relatively independent. There are no devices that are coupled in series. This embodiment of this application can also reduce the air resistance and improve the heat dissipation efficiency.

In the housing, the rectifying plate 205 is fastened on an upper housing 201, and the direct current conversion plate 208 is fastened on the lower housing 202. Devices on the rectifying plate 205 are close to devices on the direct current conversion plate 208. However, there is a gap between the devices on the rectifying plate 205 and the devices on the direct current conversion plate 208. In this state, the gap between the devices on the rectifying plate 205 and the devices on the direct current conversion plate 208 helps reduce the air resistance of the air duct, helps air flow, and improves the heat dissipation effect. In addition, the devices on the rectifying plate 205 and the devices on the direct current conversion plate 208 are not in contact with each other, so that an electromagnetic interference phenomenon is not easily caused. That the devices are not in contact with each other also reduces damage caused by mutual collision between devices, so that costs are saved.

A plurality of heat sinks 216 may further be disposed on the plurality of power switching transistors 213. The heat sinks 216 are fixedly attached to the power switching transistors 213 by using silicone grease, ceramic substrates, or screws. Each heat sink 216 corresponds to at least one power switching transistor 213 and is used for heat dissipation of the at least one power switching transistor 213. Any one of the plurality of heat sinks 216 includes a plurality of heat dissipation fins that are disposed in parallel. All the heat dissipation fins are disposed in a direction from the air inlet 203 to the air outlet 204. In this embodiment of this application, the plurality of heat sinks 216 are used for heat dissipation. Fins of the heat sinks 216 are disposed in the air duct. The fins of the heat sinks 216 are disposed in a same direction as an airflow direction. A gap between the fins of the heat sinks 216 may be used as a part of the air duct. Because the fins of the heat sinks 216 are disposed in the same direction as the airflow direction, when air flows through the gap between the fins of the heat sinks 216, the air resistance is smaller, and the heat dissipation effect is better.

In a possible embodiment, shapes of the plurality of heat sinks 216 may be rectangular. The use of the rectangular heat sinks 216 with a regular shape helps a layout design for the rectifying plate 205 and the direct current conversion plate 208, can make full use of board space, and improves power density of the board.

a shielding cover 209 is disposed on the rectifying plate 205 and is configured to shield a part of an electromagnetic wave. The shielding cover 209 is fastened at the second end portion 207 of the rectifying plate 205. An electromagnetic compatibility circuit including the plurality of magnetic devices may be disposed in the shielding cover 209. A plurality of air vents may further be disposed on the shielding cover 209 for the airflow to pass through. Because the shielding cover 209 is disposed at the second end portion 207 of the rectifying plate 205, the shielding cover 209 is close to the air outlet 204. To reduce the air resistance in the air duct, more air vents may be disposed on the shielding cover 209. In an example, a plurality of air vents are disposed on all side plates of the shielding cover 209, so that the airflow in the air duct easily flows out from the air outlet 204, and an air cooling effect is improved. In addition, the shielding cover 209 is used to shield electromagnetic interference that may be generated by the electromagnetic compatibility circuit, which helps improve stability of the power conversion circuit.

mounting heights of the plurality of heat sinks 216, the plurality of electromagnetic devices 215, and the shielding cover 209 that are disposed on the rectifying plate 205 are consistent. Mounting heights of the plurality of heat sinks 216 and the plurality of electromagnetic devices 215 that are disposed on the direct current conversion plate 208 are also consistent. That the heights of devices, such as the heat sinks 216 and the electromagnetic devices 215, on the rectifying plate 205 and the direct current conversion plate 208 are set to be consistent helps a space layout in the housing, and can implement arrangement of the power conversion circuits in small space, so that the occupied space is small. In addition, the devices of the consistent heights on the rectifying plate 205 can reduce the air resistance and noise when the airflow passes through.

It may be understood that, for differentiation, the power switching transistors 213 disposed on the rectifying plate 205 may be referred to as first power switching transistors. The power switching transistors 213 disposed on the direct current conversion plate 208 may be referred to as second power switching transistors. The capacitors 214 disposed on the rectifying plate 205 may be referred to as first capacitors. The capacitors 214 disposed on the direct current conversion plate 208 may be referred to as second capacitors. The electromagnetic devices 215 disposed on the rectifying plate 205 may be referred to as first magnetic devices. The electromagnetic devices 215 disposed on the direct current conversion plate 208 may be referred to as second magnetic devices. The heat sinks 216 disposed on the rectifying plate 205 may be referred to as first heat sinks. The heat sinks 216 disposed on the direct current conversion plate 208 may be referred to as second heat sinks.

An embodiment of this application further provides a charging pile that includes at least one the foregoing charging module and is configured to charge a power battery of a vehicle. The charging pile performs rectification and direct current conversion on an alternating current power supply by using the charging module, and finally converts the alternating current power supply to a direct current that meets a requirement of the power battery of the vehicle, to charge the battery. In a charging process, current and voltage spikes of the charging pile are small, electromagnetic interference is small, a heat dissipation effect in the module is good, noise is low, and reliability is high. Because a volume of the charging module may be miniaturized, a volume of the charging pile may be correspondingly reduced, so that an occupied area of the charging pile can be reduced, and manufacturing costs can further be reduced.

The protection scope of this application shall be subject to the protection scope of the claims.

## Claims

1. A charging module, comprising:
a housing (200), comprising an upper housing (201) and a lower housing (202) that are fitted to each other, wherein an air inlet (203) and an air outlet (204) are respectively disposed on two opposite sides of the housing (200);
a rectifying plate (205), fixedly disposed on the upper housing (201), wherein a first power conversion circuit comprising a plurality of first power switching transistors (213) is disposed on the rectifying plate (205), the rectifying plate (205) comprises a first end portion (206) and a second end portion (207), and the plurality of first power switching transistors (213) are disposed at the first end portion (206);
the first power conversion circuit further comprises a plurality of first capacitors (214) and a plurality of first electromagnetic devices (215), wherein the plurality of first capacitors (214) are disposed between adjacent first power switching transistors (213), and there is a gap between each first capacitor and the first power switching transistor (213); and the plurality of first electromagnetic devices (215) are located between the first end portion and the second end portion, and there is a gap between the plurality of first electromagnetic devices (215);
the first power conversion circuit further comprises a plurality of first heat sinks (216), fixedly attached to the first power switching transistors (213), wherein each first heat sink (216) corresponds to at least one first power switching transistor (213), and any one of the plurality of first heat sinks (216) comprises a plurality of heat dissipation fins that are disposed in parallel, and all the heat dissipation fins are disposed in a direction from the air inlet (203) to the air outlet (204);
wherein the rectifying plate (205) is further provided with: a shielding cover (209), fastened at the second end portion of the rectifying plate (205), and an electromagnetic compatibility circuit comprising a plurality of first magnetic devices is disposed in the shielding cover;
wherein mounting heights of the plurality of first heat sinks (216), the plurality of first electromagnetic devices (215), and the shielding cover (209) are consistent;
a direct current conversion plate (208), fixedly disposed on the lower housing (202), wherein a second power conversion circuit comprising a plurality of second power switching transistors (213) is disposed on the direct current conversion plate (208), and the plurality of second power switching transistors (213) are all disposed at one end portion of the direct current conversion plate (208) and are close to the first power switching transistors (213); and
an air duct is disposed between the rectifying plate (205) and the direct current conversion plate (208), the air duct is parallel to the rectifying plate and the direct current conversion plate (208), two ends of the air duct are respectively connected to the air inlet (203) and the air outlet (204).

2. The charging module according to claim 1, wherein the first end portion (206) is disposed at the air inlet (203), and the second end portion (207) is disposed at the air outlet (204).

3. The charging module according to claim 1, wherein the second power conversion circuit further comprises a plurality of second capacitors (214) and a plurality of second electromagnetic devices (215);
the plurality of second capacitors (214) are disposed between adjacent second power switching transistors (213), and there is a gap between each second capacitor (214) and the second power switching transistor (213); and
the plurality of second electromagnetic devices (215) are located on two sides of the air duct, and there is a gap between the plurality of second electromagnetic devices (215).

4. The charging module according to any one of claims 1 to 3, wherein in the housing (200), there is a gap between the rectifying plate (205) and the direct current conversion plate (208).

5. The charging module according to any one of claims 1 to 4, further comprising:
a plurality of second heat sinks (216), fixedly attached to the second power switching transistors (213), wherein each second heat sink (216) corresponds to at least one second power switching transistor (213); and
any one of the plurality of second heat sinks (216) comprises a plurality of heat dissipation fins that are disposed in parallel, and all the heat dissipation fins are disposed in a direction from the air inlet (203) to the air outlet (204).

6. The charging module according to any one of claims 1 to 5, wherein the housing (200) further comprises:
a panel (210), located at the air inlet (203) and fixedly connected to the upper housing (201) and the lower housing (202), wherein a plurality of air vents are disposed on the panel (210); and
at least one fan (211), disposed at the panel (210), mounted in the housing (200), and configured to introduce air into the housing (200).

7. A charging pile, configured to charge a power battery of a vehicle, comprising a charging pile housing, a main control board (101), and at least one charging module (102) according to any of the preceding claims, wherein the main control board (101) and the charging module (102) are disposed in the charging pile housing (200)

## Patentansprüche

1. Lademodul, umfassend:
ein Gehäuse (200), umfassend ein oberes Gehäuse (201) und ein unteres Gehäuse (202), die aneinander angebracht sind, wobei ein Lufteinlass (203) und ein Luftauslass (204) jeweils auf zwei gegenüberliegenden Seiten des Gehäuses (200) angeordnet sind;
eine Gleichrichtungsplatte (205), die fest auf dem oberen Gehäuse (201) angeordnet ist, wobei eine erste Leistungsumwandlungsschaltung, umfassend eine Vielzahl erster Leistungsschalttransistoren (213), auf der Gleichrichtungsplatte (205) angeordnet ist, die Gleichrichtungsplatte (205) einen ersten Endabschnitt (206) und einen zweiten Endabschnitt (207) umfasst und die Vielzahl erster Leistungsschalttransistoren (213) an dem ersten Endabschnitt (206) angeordnet ist;
wobei die erste Leistungsumwandlungsschaltung ferner eine Vielzahl erster Kondensatoren (214) und eine Vielzahl erster elektromagnetischer Vorrichtungen (215) umfasst, wobei die Vielzahl erster Kondensatoren (214) zwischen benachbarten ersten Leistungsschalttransistoren (213) angeordnet ist und es einen Spalt zwischen jedem ersten Kondensator und dem ersten Leistungsschalttransistor (213) gibt; und sich die Vielzahl erster elektromagnetischer Vorrichtungen (215) zwischen dem ersten Endabschnitt und dem zweiten Endabschnitt befindet und es einen Spalt zwischen der Vielzahl erster elektromagnetischer Vorrichtungen (215) gibt;
wobei die erste Leistungsumwandlungsschaltung ferner eine Vielzahl erster Wärmesenken (216) umfasst, die fest an den ersten Leistungsschalttransistoren (213) befestigt ist, wobei jede erste Wärmesenke (216) mindestens einem ersten Leistungsschalttransistor (213) entspricht und jede der Vielzahl erster Wärmesenken (216) eine Vielzahl von Wärmeableitungsrippen umfasst, die parallel angeordnet sind, und alle Wärmeableitungsrippen in einer Richtung von dem Lufteinlass (203) zu dem Luftauslass (204) angeordnet sind;
wobei die Gleichrichtungsplatte (205) ferner mit Folgendem versehen ist: einer Abschirmabdeckung (209), die an dem zweiten Endabschnitt der Gleichrichtungsplatte (205) festgemacht ist, und eine elektromagnetische Verträglichkeitsschaltung, umfassend eine Vielzahl erster magnetischer Vorrichtungen, in der Abschirmabdeckung angeordnet ist;
wobei Montagehöhen der Vielzahl erster Wärmesenken (216), der Vielzahl erster elektromagnetischer Vorrichtungen (215) und der Abschirmabdeckung (209) übereinstimmen;
eine Gleichstromumwandlungsplatte (208), die fest auf dem unteren Gehäuse (202) angeordnet ist, wobei eine zweite Leistungsumwandlungsschaltung, umfassend eine Vielzahl zweiter Leistungsschalttransistoren (213), auf der Gleichstromumwandlungsplatte (208) angeordnet ist und die Vielzahl zweiter Leistungsschalttransistoren (213) alle an einem Endabschnitt der Gleichstromumwandlungsplatte (208) angeordnet sind und den ersten Leistungsschalttransistoren (213) nahe liegen; und
ein Luftkanal zwischen der Gleichrichtungsplatte (205) und der Gleichstromumwandlungsplatte (208) angeordnet ist, der Luftkanal parallel zu der Gleichrichtungsplatte und der Gleichstromumwandlungsplatte (208) liegt, zwei Enden des Luftkanals mit dem Lufteinlass (203) beziehungsweise dem Luftauslass (204) verbunden sind.

2. Lademodul nach Anspruch 1, wobei der erste Endabschnitt (206) an dem Lufteinlass (203) angeordnet ist und der zweite Endabschnitt (207) an dem Luftauslass (204) angeordnet ist.

3. Lademodul nach Anspruch 1, wobei die zweite Leistungsumwandlungsschaltung ferner eine Vielzahl zweiter Kondensatoren (214) und eine Vielzahl zweiter elektromagnetischer Vorrichtungen (215) umfasst;
die Vielzahl zweiter Kondensatoren (214) zwischen benachbarten zweiten Leistungsschalttransistoren (213) angeordnet ist und es einen Spalt zwischen jedem zweiten Kondensator (214) und dem zweiten Leistungsschalttransistor (213) gibt; und
sich die Vielzahl zweiter elektromagnetischer Vorrichtungen (215) auf zwei Seiten des Luftkanals befindet und es einen Spalt zwischen der Vielzahl zweiter elektromagnetischer Vorrichtungen (215) gibt.

4. Lademodul nach einem der Ansprüche 1 bis 3, wobei es in dem Gehäuse (200) einen Spalt zwischen der Gleichrichtungsplatte (205) und der Gleichstromumwandlungsplatte (208) gibt.

5. Lademodul nach einem der Ansprüche 1 bis 4, ferner umfassend:
eine Vielzahl zweiter Wärmesenken (216), die fest an den zweiten Leistungsschalttransistoren (213) befestigt ist, wobei jede zweite Wärmesenke (216) mindestens einem zweiten Leistungsschalttransistor (213) entspricht; und
jede beliebige der Vielzahl zweiter Wärmesenken (216) eine Vielzahl von Wärmeableitungsrippen umfasst, die parallel angeordnet sind, und alle Wärmeableitungsrippen in einer Richtung von dem Lufteinlass (203) zu dem Luftauslass (204) angeordnet sind.

6. Lademodul nach einem der Ansprüche 1 bis 5, wobei das Gehäuse (200) ferner Folgendes umfasst:
ein Paneel (210), das sich an dem Lufteinlass (203) befindet und fest mit dem oberen Gehäuse (201) und dem unteren Gehäuse (202) verbunden ist, wobei eine Vielzahl von Belüftungsöffnungen auf dem Paneel (210) angeordnet ist; und
mindestens ein Gebläse (211), das an dem Paneel (210) angeordnet, in dem Gehäuse (200) montiert und dazu konfiguriert ist, Luft in das Gehäuse (200) einzuleiten.

7. Ladesäule, die dazu konfiguriert ist, eine Leistungsbatterie eines Fahrzeugs zu laden, umfassend ein Ladesäulengehäuse, eine Hauptsteuerplatine (101) und mindestens ein Lademodul (102) nach einem der vorhergehenden Ansprüche, wobei die Hauptsteuerplatine (101) und das Lademodul (102) in dem Ladesäulengehäuse (200) angeordnet sind.

## Revendications

1. Module de charge, comprenant :
un boîtier (200), comprenant un boîtier supérieur (201) et un boîtier inférieur (202) qui sont ajustés l'un à l'autre, dans lequel une entrée d'air (203) et une sortie d'air (204) sont respectivement disposées sur deux côtés opposés du boîtier (200) ;
une plaque de redressement (205), disposée de manière fixe sur le boîtier supérieur (201), dans lequel un premier circuit de conversion de puissance comprenant une pluralité de premiers transistors de commutation de puissance (213) est disposé sur la plaque de redressement (205), la plaque de redressement (205) comprend une première partie d'extrémité (206) et une seconde partie d'extrémité (207), et la pluralité de premiers transistors de commutation de puissance (213) sont disposés à la première partie d'extrémité (206) ;
le premier circuit de conversion de puissance comprend également une pluralité de premiers condensateurs (214) et une pluralité de premiers dispositifs électromagnétiques (215), dans lequel la pluralité de premiers condensateurs (214) sont disposés entre des premiers transistors de commutation de puissance adjacents (213), et il existe un espace entre chaque premier condensateur et le premier transistor de commutation de puissance (213) ; et
la pluralité de premiers dispositifs électromagnétiques (215) sont situés entre la première partie d'extrémité et la seconde partie d'extrémité, et il existe un espace entre la pluralité de premiers dispositifs électromagnétiques (215) ;
le premier circuit de conversion de puissance comprend également une pluralité de premiers dissipateurs thermiques (216), fixés de manière fixe aux premiers transistors de commutation de puissance (213), dans lequel chaque premier dissipateur thermique (216) correspond à au moins un premier transistor de commutation de puissance (213), et chacun de la pluralité de premiers dissipateurs thermiques (216) comprend une pluralité d'ailettes de dissipation de chaleur disposées en parallèle, et toutes les ailettes de dissipation de chaleur sont disposées dans une direction allant de l'entrée d'air (203) à la sortie d'air (204) ;
dans lequel la plaque de redressement (205) est également munie : d'un couvercle de blindage (209), fixé à la seconde partie d'extrémité de la plaque de redressement (205), et un circuit de compatibilité électromagnétique comprenant une pluralité de premiers dispositifs magnétiques est disposé dans le couvercle de blindage ;
dans lequel des hauteurs de montage de la pluralité de premiers dissipateurs thermiques (216), de la pluralité de premiers dispositifs électromagnétiques (215) et du couvercle de blindage (209) sont cohérentes ;
une plaque de conversion de courant continu (208), fixée sur le boîtier inférieur (202), dans lequel un second circuit de conversion de puissance comprenant une pluralité de seconds transistors de commutation de puissance (213) est disposé sur la plaque de conversion de courant continu (208), et la pluralité de seconds transistors de commutation de puissance (213) sont tous disposés à une partie d'extrémité de la plaque de conversion de courant continu (208) et sont proches des premiers transistors de commutation de puissance (213) ; et
un conduit d'air est disposé entre la plaque de redressement (205) et la plaque de conversion de courant continu (208), le conduit d'air est parallèle à la plaque de redressement et à la plaque de conversion de courant continu (208), deux extrémités du conduit d'air sont respectivement connectées à l'entrée d'air (203) et à la sortie d'air (204).

2. Module de charge selon la revendication 1, dans lequel la première partie d'extrémité (206) est disposée à l'entrée d'air (203), et la seconde partie d'extrémité (207) est disposée à la sortie d'air (204).

3. Module de charge selon la revendication 1, dans lequel le second circuit de conversion de puissance comprend également une pluralité de seconds condensateurs (214) et une pluralité de seconds dispositifs électromagnétiques (215) ;
la pluralité de seconds condensateurs (214) sont disposés entre des seconds transistors de commutation de puissance adjacents (213), et il existe un espace entre chaque second condensateur (214) et le second transistor de commutation de puissance (213) ; et
la pluralité de seconds dispositifs électromagnétiques (215) sont situés de deux côtés du conduit d'air, et il existe un espace entre la pluralité de seconds dispositifs électromagnétiques (215).

4. Module de charge selon l'une quelconque des revendications 1 à 3, dans lequel dans le boîtier (200), il existe un espace entre la plaque de redressement (205) et la plaque de conversion de courant continu (208).

5. Module de charge selon l'une quelconque des revendications 1 à 4, comprenant également :
une pluralité de seconds dissipateurs thermiques (216), fixés de manière fixe aux seconds transistors de commutation de puissance (213), dans lequel chaque second dissipateur thermique (216) correspond à au moins un second transistor de commutation de puissance (213) ; et
l'un quelconque de la pluralité de seconds dissipateurs thermiques (216) comprend une pluralité d'ailettes de dissipation de chaleur disposées en parallèle, et toutes les ailettes de dissipation de chaleur sont disposées dans une direction allant de l'entrée d'air (203) à la sortie d'air (204).

6. Module de charge selon l'une quelconque des revendications 1 à 5, dans lequel le boîtier (200) comprend également :
un panneau (210), situé à l'entrée d'air (203) et connecté de manière fixe au boîtier supérieur (201) et au boîtier inférieur (202), dans lequel une pluralité d'orifices de ventilation sont disposés sur le panneau (210) ; et
au moins un ventilateur (211), disposé au niveau du panneau (210), monté dans le boîtier (200) et configuré pour introduire de l'air dans le boîtier (200).

7. Pile de charge, configurée pour charger une batterie d'un véhicule, comprenant un boîtier de pile de charge, une carte de commande principale (101) et au moins un module de charge (102) selon l'une quelconque des revendications précédentes, dans laquelle la carte de commande principale (101) et le module de charge (102) sont disposés dans le boîtier de pile de charge (200)
